# EUROPEAN PATENT APPLICATION

(11) **EP 4 576 098 A1**
(43) Date of publication of application: **25.06.2025**
(21) Application number: 23307290.9
(22) Date of filing: 20.12.2023
(51) Int. Cl.: G11C 16/22, G11C 7/24, G11C 16/26, G11C 16/32, G11C 7/08, G11C 7/22, G11C 7/12, G11C 16/24

(54) **SECURE NON-VOLATILE MEMORY AND INTEGRATED CIRCUIT INCLUDING SAID NON-VOLATILE MEMORY**

(71) Applicant: THALES DIS FRANCE SAS, 92190 Meudon (FR)
(72) Inventor: NAURA, David, 13100 Aix en Provence (FR); GIOVINAZZI, Thierry, 83470 Saint Maximin La Sainte Baume (FR)
(74) Representative: Bricks, Amélie

(57) **Abstract**

The invention relates to non-volatile memory circuit comprising a plurality of memory cells, a synchronization circuit for providing internal synchronization signals for controlling read amplifiers and performing a read operation on at least one of the memory cells when a reading signal is activated. The non-volatile memory comprises at least one check circuit (390), said check circuit (390) receiving at least one internal synchronization signal (ATD, SEN, DLA) and providing at least one check signal (CHKATD, CHKSEN, CHKDLA), said check signal toggling each time an internal synchronization signal (ATD, SEN, DLA) comprises an active edge.

## Description

### Technical Field

The invention relates to a secure non-volatile memory and secure integrated circuit including said non-volatile memory.

### Background Art

Secure integrated circuits are more and more used today. As an example, secure integrated circuit are used for any product needing a secure element like smart cards, smartphones, computers, or any communicating electronic device that should be securely connected. Security data, including password but also secure programs for making strong authentications are stored in a non-volatile memory that are preferably programmable and erasable, like Flash memories or EEPROMs (Electrically Erasable Programmable Read Only Memory) but ROM can also be concerned by the storing of security information. The non-volatile memory is embedded into a microcontroller or a System-on-Chip (SoC) component making a verification of password in such a way the password never goes out of the component. Nevertheless, there are some methods for retrieving the password from such component.

One method consists in a direct access to the component after removing protection resin from the component. Once the component is naked, the buses and the memory can be accessed by thin probe or by laser. In such a way to avoid a direct reading of the memory, the memory can be scrambled or encoded.

Even if the memory is scrambled or encoded, a method, known as "fault attack", consists in altering the reading of the memory in such a way to cause some faults during the running of a secure program for locating where are the sensitive data or for deducing an algorithm.

A laser attack can be made of different manner at different location in the component. A laser attack can be made on a control bus between a processor unit and a memory or on synchronization signals inside the memory for avoiding a reading operation making a replay of the previous read data. Such kind of replay attack can be detected by the processor if it occurs on the control bus between the processor and a memory controller. Nevertheless, the processor cannot detect such an attack when it is made between the memory controller and a non-volatile memory or directly on the synchronization signals of the non-volatile memory. There is a need to detect such an attack for stopping the running of a secure program.

### Summary of the Invention

The invention provides a secure memory including a check circuit for sending back an information related to the execution of an operation. Said information is a dynamic information enabling a memory controller to control that the operation has been correctly performed inside the memory. Typically, the information can be a signal toggling each time an internal synchronization signal is used in the memory.

More particularly, the invention provides a method for detecting a reading error caused by a photoelectric or radiative attack of an integrated circuit comprising a non-volatile memory having a synchronization circuit for providing internal synchronization signals for controlling read amplifiers and performing a read operation when a reading signal is activated. The non-volatile memory provides at least one check signal, said check signal toggling each time an internal synchronization signal comprises an active edge. The check signal can be exploited for triggering an alarm signal, in particular when the integrated circuit comprises at least one memory controller interfacing the non-volatile memory with other elements of said integrated circuit. The memory controller can activate the reading signal in response to the reception of a read command from the other elements of the integrated circuit. The memory controller can monitor the at least one check signal and can verify after each reception of the read command that the check signal has toggled following the reception of the last read command. The memory controller can activate an alarm signal when the check signal has not toggled.

Preferably, the memory can provide several check signals, and the memory controller can verify after each reception of the read command that all the check signals have toggled and can activate an alarm signal when at least one of the check signals has not toggled.

According to another aspect, the invention provides a non-volatile memory circuit comprising a plurality of memory cells, a synchronization circuit for providing internal synchronization signals for controlling read amplifiers and performing a read operation on at least one of the memory cells when a reading signal is activated. The non-volatile memory circuit comprises at least one check circuit, said check circuit receiving at least one internal synchronization signal and providing at least one check signal, said check signal toggling each time an internal synchronization signal comprises an active edge.

Preferably, the check circuit receives a plurality of internal synchronization signals and provides a plurality of check signals.

According to a preferred embodiment, the check circuit can comprise a toggle flip-flop receiving on a clock input one of the internal synchronization signals for toggling an output each time the internal synchronization signal comprises an active edge.

The invention also relates to an integrated circuit comprising a non-volatile memory according to the invention, said integrated circuit comprising at least one memory controller activating the reading signal in response to the reception of a read command. The memory controller comprises a monitoring circuit receiving at least one check signal, and the read command. The monitoring circuit activates an alarm signal when the check signal has not toggled following the reception of a read command.

According to a first embodiment, the monitoring circuit can comprise a first D-latch having one input receiving one of the check signals, a second D-latch having one input connected to an output of the first D-latch, and an XOR-type gate having one input connected to the output of the first D-latch and another input connected to an output of the second D-latch, the first and second D-latches having a clock input receiving the read command and wherein the output of the XOR-type gate can provide the alarm signal.

Preferably, the monitoring circuit can activate the alarm signal when at least one of the check signals has not toggled following the reception of a read command.

According to a second embodiment, the monitoring circuit can comprise a plurality of first D-latches, each having one input receiving one of the check signals, a plurality of second D-latches, each having one input connected to an output of one of the first D-latches, a plurality of XOR-type gates, each having one input connected to the output of one of the first D-latch and another input connected to an output of one of the second D-latch, and an AND-type gate having a plurality of inputs, each connected to an output of each XOR-type gate, all the first and second D-latches having a clock input receiving the read command and wherein the output of the AND-type gate can provide the alarm signal.

### Brief description of the Drawings

The invention will be detailed with reference to the annexed drawings in which:
Figure 1 shows an integrated circuit including a non-volatile memory,
Figure 2 shows a first structure of a non-volatile memory circuit according to the invention,
Figure 3 details a part of a bit line during a reading operation,
Figure 4 shows a timing diagram of a reading operation in normal condition,
Figure 5 details a check circuit according to the invention,
Figure 6 shows a timing diagram of a reading operation during a first attack condition,
Figure 7 details a monitoring circuit according to a first embodiment,
Figure 8 shows a timing diagram related to the monitoring circuit of figure 7
Figure 9 to 11 show timing diagrams of a reading operation during three other attack conditions,
Figure 12 details a monitoring circuit according to a second embodiment.

### Detailed Description of the invention

In such a way to simplify the present specification, a same reference is used on different drawings for designing a same element or an equivalent element. In addition, only parts of the memory are shown on the drawings for avoiding a surcharge that may render the drawings unreadable. Timing diagrams are not made with an exact scale for showing details that cannot be shown otherwise.

In the present document, it will be made reference to active signal, inactive signal, high level, low level, level "1" and level "0". As well known by a person skilled in the art, levels "0" and "1" and a low or a high level can arbitrarily correspond to an active and inactive levels depending on the kind of transistor used or of a simple choice of the designer. So, changing a high level to a low level or a level "1" to a level "0" has no importance in relation with the invention.

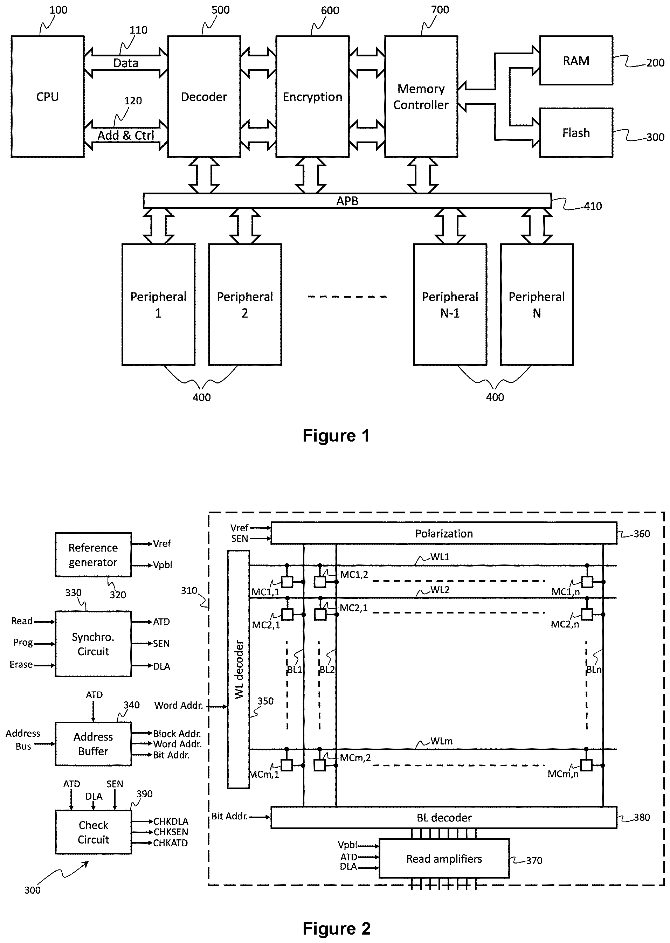

An integrated circuit of a microcontroller type, which can be also a System-on-Chip (SOC), is shown on figure 1 for showing the context in which the invention is used. The integrated circuit of figure 1 comprises a central processing unit (CPU) 100 that may include one or more microprocessor cores. The CPU 100 comprises a data bus 110, and an address and control bus 120 for communicating with memories 200 and 300 and with peripheral units 400. For securely managing the memories 200 and 300 or the peripheral units 400, the integrated circuit can comprise a decoder circuit 500, an encryption circuit 600 and a memory controller 700, both connected to the data bus 110 and the address and control bus 120 and to an application peripheral bus (APB) 410 for connecting the peripheral units 400.

Typically, control signals and address format depend on the memory type, and it is necessary to adapt them to be transparent for the CPU. The memory controller 700 can be used for addressing each memory 200 or 300 with address and control signals adapted to each type of memory that can be volatile memory 200, for example of RAM type, or non-volatile memory, for example of Flash type.

The encryption circuit 600 can be used for secure circuit, it can be of different type and can be controlled by the CPU for encrypting the data transmitted to the memories or to the peripheral units or for scrambling the addresses of the data into one memory. The encryption circuit 600 can be also transparent if no security is required for the transferred data.

The decoder circuit 500 can be used for decoding some control signals of the CPU in such a way to address the memories 200 or 300, one peripheral unit 400, or to control the encryption circuit 600 or for establishing a data transfer between one of the memories 200 or 300 and one peripheral unit 400, eventually through the encryption circuit 600.

Many other architectures are possible using different communication path between a CPU, its memories, and its peripherals units. Figure 1 showing only one example amongst many other possibilities, many functional variants of the decoder circuit 500, the encryption circuit 600, and the memory controller 700 are possible and they can be also optional. For the invention, one important thing is that a CPU 100 is connected directly or indirectly to a non-volatile memory 300 in view to read data that can be encrypted or scrambled or not. According to the invention the non-volatile memory 300 is capable to send back a check signal to the CPU 100 or to any of the intermediate components for indicating a reading operation has been performed.

The figure 2 illustrates an example of a non-volatile memory 300 according to the invention, for example a Flash memory, having a size that is small enough to be implemented into a SOC. The memory 300 can comprise one or more memory blocks 310 but only one is represented for simplifying the drawing. The memory further comprises a reference generator 320, a synchronization circuit 330 and an address buffer 340 for synchronizing the memory. For simplification reasons, only signals used for a reading operation are indicated on the drawing.

The memory block 310 comprises a plurality of word lines WL1 to WLm, a plurality of bit lines BL1 to BLn and a plurality of memory cells MC1,1 to MCm,n, each memory cell MCj,i being located and connected at the intersection of one word line WLj with one bit line BLi. The memory block 310 further comprises a word line decoder 350, a polarization circuit 360, read amplifiers 370, a bit line decoder 380 and a check circuit 390.

The reference generator 320 provides a first reference voltage Vref and a second reference voltage Vpbl. The reference generator 320 contains a stabilized current source and the first reference voltage Vref corresponds to the intermediate voltage of a current mirror which is provided to the polarization circuit 360 for enabling the polarization circuit 360 to mirror and to provide this stabilized current to each bit line BL1 to BLn in such a way to polarize said bit lines BL1 to BLn with a constant current. The second reference voltage Vpbl corresponds to a preload voltage of the bit line used for starting each reading operation.

The synchronization circuit 330 receives the external control signals provided by the memory controller 700 which correspond to a reading signal READ, a programing signal Prog and an erasing signal Erase. Each of these signals READ, Prog and Erase triggers a sequence of signals to the different circuits constituting the memory circuit 300 for providing the requested operation. In the present specification, only the signals used for a reading operation will be detailed. The activation of the reading signal READ triggers an address validation signal ATD, a sensing signal SEN, and a data latching signal DLA with timing detailed later in this document. The address validation signal ATD is provided to the address buffer 340 and to the read amplifier 370. The sensing signal SEN is provided to the polarization circuit 360. The data latching signal DLA is provided to the read amplifiers 370.

The address buffer 340 receives the address of the data to be read from an address bus connected to the memory controller 700. The address can be multiplexed by the CPU 100, and can be demultiplexed by said memory controller, as well known by a person skilled in the art. In this document, the full address is received in parallel by the address buffer 340 from the memory controller 700. The address buffer 340 memorizes the full address at the beginning of the read operation triggered by the address validation signal ATD and till the end of the read operation for providing different address segments to several elements of the memory 300. A first segment is the block address that controls the powering of the memory block into which the reading operation is to be performed. A second segment is the word address which is sent to the word line decoder 350 for selecting one word line WLj. A third segment is the bit line address which is sent to the bit line decoder 380 for selecting one or more bit lines that correspond to the read data, depending on the number of bits that are corresponding to a data word.

The word line decoder 350 is a demultiplexer circuit that provides an active level to one word line WLj corresponding to the word address provided by the address buffer 340 while the other word lines are at an inactive level. The word line decoder 350 selects the reading of all the memory cells MCj, 1 to MCj,n connected to the selected word line WLj.

The polarization circuit 360 provides a same and constant current to all the bit lines BL1 to BLn when the sensing signal SEN is active. The constant current polarizes the bit lines BL1 to BLn and participates to the charging and discharging of said bit line BL1 to BLn during the reading of the memorized value of the selected memory cells MCj,1 to MCj,n connected to the bit lines BL1 to BLn.

The read amplifiers 370 comprise amplification circuits connected to bit lines for reading the value of selected cells after a reading time. In view to read the value, the read amplifiers 370 charge the bit line to the second reference voltage Vpbl under the control of the address validation signal ATD. Then, the bit lines are charged or discharged during a reading time, and the read values are latched by the data latching signal DLA.

The bit line decoder 380 is a multiplexer connected between the read amplifiers 370 and the memory cells MCj,i for selecting the bit lines to be read. With such a selection of bit lines, the number of read amplifiers 370 can be reduced to the number of bits of a data word instead of having has many amplifiers than bit lines. Such a selection can also enable to reduce the size of the polarization circuit 360.

The check circuit 390 receives the address validation signal ATD, the sensing signal SEN, and the data latching signal DLA. The check circuit 390 provides check signals CHKATD, CHKSEN and CHKDLA that are respectively representative of the activation of the address validation signal ATD, the sensing signal SEN and the data latching signal DLA.

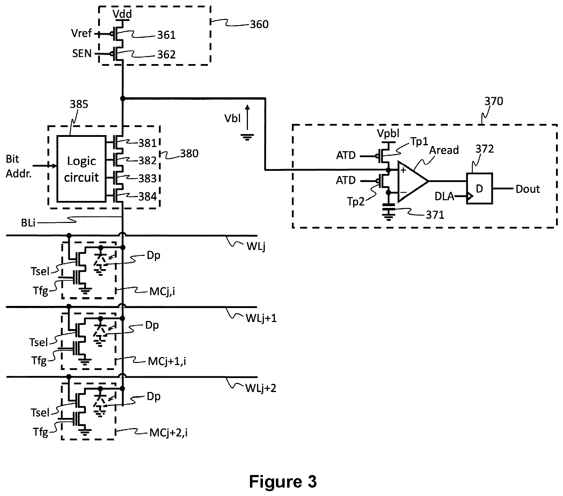

Other memory structure can implement the invention. The place of the elements can be moved for optimizing the placing without changing the function. In view to explain how is made a reading operation with and without attack, the figure 3 details the different elements of the memory 300 in relation with one bit line BLi.

As it can be seen on the figure 3 the elements of figure 2 are not located at the same places and enable to reduce the size of the polarization circuit 360.

For simplifying the drawings, only three word lines WLj, WLj+1 and WLj+2 are represented but, as well known by a person skilled in the art, the number m of word lines is much higher, for example m can be equal to 2¹⁰. The polarization circuit 360, the read amplifiers 370, and the bit line decoder 380 are limited to their components connected only to one bit line BLi.

The bit line decoder 380 comprises decoding transistors 381 to 384 serially mounted between the selected bit line BLi and the read amplifiers 370. The bit line decoder 380 comprises a logic circuit 385 that decodes the bit line address for controlling said decoding transistors 381 to 384. A person skilled in the art will understand that the polarization circuit 360 and the read amplifiers 370 are also connected to other bit lines through other decoding transistors (not shown) that are unselected by the bit line decoder 380. In addition, the polarization circuit 360, the read amplifiers 370, the decoding transistors 381 to 384 are repeated for each group of bit lines corresponding to another bit of the data which is read simultaneously.

As it can be seen on figure 3, the polarization circuit 360 comprises a mirror transistor 361 and a sensing transistor 362. The source of the mirror transistor 361 is connected to the supply voltage while its gate is connected to an input of the polarization circuit 360 receiving the first reference voltage Vref. The mirror transistor 361 is identical to a transistor located into the reference generator 320 for mirroring a reference current used for polarizing the bit line BLi at a constant current. The channel of the sensing transistor 362 is connected between the bit line BLi and the drain of the mirror transistor 361. The sensing transistor 362 is driven by the sensing signal SEN in such a way to provide the constant current to the bit line BLi only when the sensing signal SEN is active at a low level.

The read amplifiers 370 comprise a differential amplifier Aread, first and second preload transistors Tp1 and Tp2, a capacitor 371 and a latch 372 of D type. The differential amplifier Aread comprises two inputs and provides at its output a signal corresponding to the amplified difference between its inputs. A drain of first preload transistor Tp1 and a source of the second preload transistor Tp2 are connected to one of the inputs of the differential amplifier Aread. A drain of the second preload transistor Tp2 is connected to the other of the inputs of the differential amplifier Aread. A source of the first preload transistor Tp1 is connected to the reference generator for receiving the second reference voltage Vpbl. The capacitor 371 is connected between the drain of the second preload transistor Tp2 and the ground of the memory circuit 300. The gates of the first and second preload transistors Tp1 and Tp2 both receive the address validation signal ATD for charging the capacitor 371 and the bit line BLi to the second reference voltage Vpbl when the address validation signal ATD is active. The latch 372 is connected at the output of the differential amplifier Aread for latching the read data under the control of the data latching signal DLA.

Each memory cell MCj,i comprises a floating gate transistor Tfg and a selection transistor Tsel. A gate of the selection transistor Tsel is connected to the word line WLj. A drain of the selection transistor Tsel is connected to the bit line BLi. A source of the selection transistor Tsel is connected to the drain of the floating gate transistor Tfg. A source of the floating gate transistor Tfg is connected to a ground voltage. The gate of the floating gate transistor Tfg is used for erasing and programming the bit memorized by the floating gate transistor and can be unconnected or can be polarized with a reading voltage for adjusting the current in the memory cell MCj,i during the reading operation. The memory cell MCj,i memorizes a bit value corresponding to a quantity of charges accumulated in the floating gate of the floating gate transistor Tfg. The value "0" or "1" of a memorized bit can be arbitrarily associated to the fact that the floating gate is charged or discharged. In the present document the bit value "0" corresponds to charged floating gate.

In addition, the selection transistor Tsel of each cell being a N-channel transistor made on a P-substrate, a parasitic diode Dp is reverse connected between the bit line BLi and the ground voltage. This parasitic diode Dp is normally always blocked and corresponds electrically to a small capacitor. The small capacitor multiplied by the number of memory cells MCj,i connected to the bit line BLi defines the total capacitance of the bit line BLi.

The person skilled in the art knows that such kind of memory is sized to be small with a low consumption. The size of the transistors constituting the memory cells MCj,i limits the current flowing through the memory cells and defines the global capacitance of the bit line BLi. In addition, each memory cell MCj,i, can have a current leakage, and a global current leakage must be considered. As an example, if the global current leakage is around 1,5 µA, the floating gate transistor (Tfg) can be sized for enabling to pass a current of 11,5 µA, while the polarization circuit 360 provides a constant current of 6,5 µA, in such a way that the bit line can be charged or discharged with a current of +/- 5 µA. The time for totally charging or discharging the bit line BLi depends on the number of cells connected to the bit line and can be around 40 ns for a complete charging with 2¹⁰ memory cells connected to one bit line. For preloading the bit line, the first preload transistor Tp1 (which are in lower number than memory cells) can be much larger for reducing the preload time for example to 2 ns.

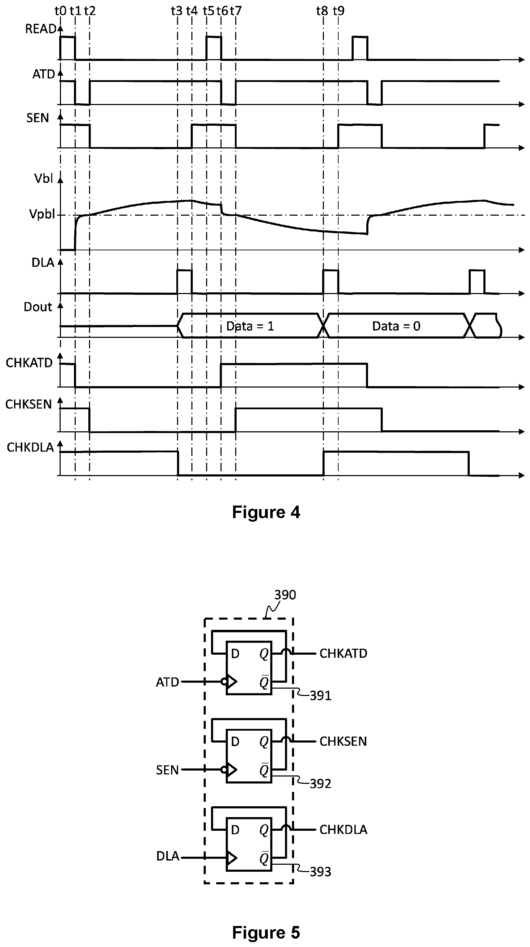

Before detailing the detection of an attack, a normal reading operation in the memory 300 is detailed in relation with figure 4. A reading operation can be initiated by the CPU 100, or by one peripheral unit 400. The reading operation is managed by the memory controller 700 after the reception of one or more instructions enabling the memory controller to determine an address in the memory and indicating that a reading operation is requested by a read command on the control bus 120 or on the APB bus 410. The timing charts of figure 4 relates to the signals around and inside the memory 300.

For reading a data word, the address bus of the non-volatile memory 300 should be charged by the memory controller 700 with an address corresponding to a data word to be read, as an example the data word to be read comprises a bit located in the memory cell MCj,i. Then the memory controller 700 activate the reading signal READ at time t0 for indicating to the non-volatile memory 300 that a read operation must be performed. In response to the reading signal READ, the synchronization circuit 330 activates the address validation signal ATD at a time t1 till a time t2. As an example, time t1 can be set 2 ns after time t0 and time t2 can be set 2 ns after time t1. The activation of the address validation signal ATD causes the address buffer 340 to memorize the address at time t1. The address buffer 340 provides immediately at the time t1 the block address to switch on the selected memory block, and the bit address corresponding to the bit line BLi for connecting the selected bit line BLi through the decoding transistors 381 to 384.

During the activation of the address validation signal ATD, the first and second preload transistors Tp1 and Tp2 are switched on and the bit line BLi is preload to the second reference voltage Vpbl. It should be noted by the person skilled in the art that the channel width of the first preload transistor Tp1 must be sized for driving the bit line voltage at the second reference voltage Vpbl before the time t2.

At time t2, the address buffer 340 provides the word address that selects the word line WLj. The selection transistor Tsel of memory cell MCj,i switches to a conducting state at this moment.

At time t2, the synchronization circuit 330 deactivates the address validation signal ATD and activates sensing signal SEN. The deactivation of the address validation signal ATD blocks the first and second preload transistors Tp1 and Tp2. The activation of the sensing signal SEN connects the mirror transistor 361 to the bit line BLi through the sensing transistor 362. Considering that the floating gate of the floating gate transistor Tfg of memory cell MCj,i is discharged, the floating gate transistor Tfg of the selected memory cell MCj,i is in open circuit. The stabilized current provided by the mirror transistor 361 can charge the capacitance of the bit line BLi, increasing the bit line voltage Vbl.

At time t3, the synchronization circuit 330 activates the data latching signal DLA. The bit line BLi being at a voltage higher than the second reference voltage Vpbl memorized by the capacitor 371, the output of the differential amplifier is at high level, and the latch 372 memorizes and provides at its output a bit value equal to "1". It should be noted that the time t3 is set to a value corresponding to a sufficient time for significatively charging or discharging the bit line for having a good reading of the cell level, but it is not necessary to wait a complete charging or discharging of the bit line. As an example, time t3 can be set to 20 ns after time t2 for warranting that the charging or discharging of bit line enables to have a good reading whatever the wear of the floating gate transistors.

At a time t4, after time t3, for example 1 ns later, the synchronization circuit 330 deactivates the sensing signal SEN and a new reading operation can be initiated by the memory controller 700, presenting a new address, as an example the data to be read comprises a bit located in the memory cell MCj+1,i and containing a "0" value. The memory controller 700 activates the reading signal READ at time t5 for indicating to perform a new read operation. In response, the synchronization circuit 330 activates the address validation signal ATD at a time t6 till time t7.

The first and second preload transistors Tp1 and Tp2 preload the bit line BLi at the second reference voltage Vpbl before the time t7. At time t7, the address buffer 340 provides the word address that selects the word line WLj+1. The selection transistor Tsel of memory cell MCj+1,i switches to a conducting state at this moment.

At time t7, the synchronization circuit 330 deactivates the address validation signal ATD and activates sensing signal SEN. The deactivation of the address validation signal ATD blocks the first and second preload transistors Tp1 and Tp2. The activation of the sensing signal SEN connects the mirror transistor 361 to the bit line BLi through the sensing transistor 362. Considering that the floating gate of the floating gate transistor Tfg of memory cell MCj+1,i is charged, the floating gate transistor Tfg of the selected memory cell MCj,i is in a conducting state. The stabilized current provided by the mirror transistor 361 is driven to the ground together with the charges of the bit line BLi, decreasing the bit line voltage Vbl.

At time t8, the synchronization circuit 330 activates the data latching signal DLA. The bit line BLi being at a voltage lower than the second reference voltage Vpbl memorized by the capacitor 371, the output of the differential amplifier is at low level, and the latch 372 memorizes and provides at its output a bit value equal to "0". Another read operation can be performed after a time t9 corresponding to a deactivation of the sensing signal SEN.

In view to enable that a reading operation was regularly made, the check circuit 390 of figure 5 can be used. The check circuit 390 comprises first to third toggle flip-flops 391 to 393. The first toggle flip-flop 391 receives the address validation signal ATD and provides a first check signal CHKATD. The second toggle flip-flop 392 receives the sensing signal SEN and provides a second check signal CHKSEN. The third toggle flip-flop 393 receives the data latching signal DLA and provides a third check signal CHKDLA. Each of the first to third toggle flip-flops 391 to 393 can be made with a D-latch having its inverted output *Q̅* connected to its D input, the output *Q* providing the corresponding check signal CHKATD, CHKSEN, and CHKDLA. The clock signal of the D-latch of the first toggle flip-flop 391 receives the address validation signal ATD and is activated on a falling edge. The clock signal of the D-latch of the second toggle flip-flop 392 receives the sensing signal SEN and is activated on a falling edge. The clock signal of the D-latch of the third toggle flip-flop 393 receives the data latching signal DLA and is activated on a rising edge.

In this example, the memory 300 uses three internal synchronization signals corresponding respectively to the address validation signal ATD, the sensing signal SEN, and the data latching signal DLA. Consequently, the check circuit 390 comprises three flip-flops 391 to 393, one for each internal synchronization signal. But the number of internal synchronization signals may vary from one type of memory to another type of memory. So, the number of flip-flops and the number of checks signals can also vary. In addition, depending on a choice of detection, it is not necessary to have a check signal for each internal synchronization signal. Also, the use of falling edge or rising edge depends whether the internal synchronization signal is active at low state or at high state, what is important is to use the first edge of the internal synchronization signal used during the reading operation.

As it can be seen on figure 4, each of the first to third check signal CHKATD, CHKSEN, and CHKDLA toggles at each rising or falling edge of the corresponding internal synchronization signal ATD, SEN, and DLA. Such a toggling of check signal enables to verify that all the internal synchronization signals have been activated during a reading operation.

In the present example, the use of falling edge or rising edge depends on the fact that the internal synchronization signal is active at low state or at high state, for toggling once the internal synchronization signal becomes active. This is a pure choice of design, and, for the invention, what is important is that the check signal toggles on one edge of the internal synchronization signal in such a way to indicate that the internal synchronization signal has been used during the reading operation.

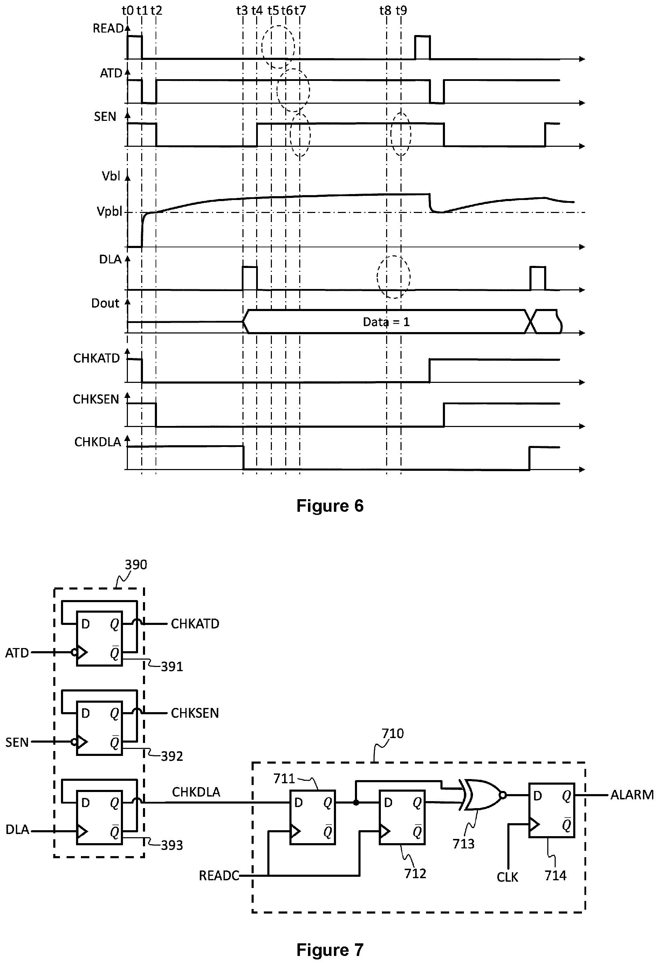

To explain how the check signals CHKATD, CHKSEN, and CHKDLA can be used for detecting an attack, figures 6, 9, 10 and 11 show different attacks. These figures 6, 9, 10 and 11 show timing charts corresponding to the two reading operations detailed in relation with figure 4 but with an attack made on the second reading. For conciseness, only the major difference with figure 4 are detailed.

Figure 6 shows an attack in which the reading signal READ has been neutralized at time t5. Consequently, the internal synchronization signals ATD, SEN and DLA are not activated at time t6, t7 and t8 as it is shown on figure 4. The consequence is that no read operation is performed between time t5 and t9 and that the latch 372 continues to memorize the previous read bit which is "1" instead of reading the bit "0" as in figure 4. None of the check signals CHKATD, CHKSEN, and CHKDLA toggles between t5 and t9.

The attack shown on figure 6 can be detected on only one of the check signals CHKATD, CHKSEN, and CHKDLA. For detecting the attack, one of the check signals CHKATD, CHKSEN, and CHKDLA can be transmitted to the CPU 100 and the CPU can make a detection on the check signals. Nevertheless, such kind of detection takes some processing time and can strongly increase the execution time of a program if a verification is made after each reading operation. According to the invention, a hardware circuit can be included for making such a detection, for example in the memory controller 700.

Figure 7 shows an example of a monitoring circuit 710 that is included in the memory controller 700 for detecting an attack and for raising an alarm signal ALARM when an attack is detected. The monitoring circuit 710 comprises a signal input receiving only one of the check signals CHKATD, CHKSEN, and CHKDLA, a clock input receiving the read command READC coming from the CPU 100 or from one peripheral unit 400, and an output providing the alarm signal ALARM when the check signal CHKATD, CHKSEN, or CHKDLA has not toggled following the reception of a read command READC.

The monitoring circuit 710 can comprise a first D-latch 711, a second D-latch 712, an XNOR gate 713, and optionally a third D-latch 714. The first to third D-latches 711, 712 and 714 each comprise a signal input, a clock input, and an output reproducing and memorizing the signal input each time an active edge is received on its clock input. The signal input of the first D-latch 711 receives one of the check signals CHKATD, CHKSEN, and CHKDLA. The signal input of the second D-latch 712 is connected to the output of the first D-latch 711. The clock input of the first and second D-latches receives the read command READC. The XNOR gate 713 has two inputs, one input being connected to the output of the first D-latch 711 and the other input being connected to the output of the second D-latch 712. The output of the XNOR gate 713 provides the alarm signal ALARM to the signal input of the third D-latch 714. The clock input of the third D-latch 714 receives a clock signal CLK which is a global clock signal of the integrated circuit that can be used for clocking the control bus. The third D-latch 714 is used for formatting the alarm signal ALARM in such a way the alarm signal is synchronized with other information exchanged on the control bus and can also prevent having false raising of the alarm signal ALARM caused by a glitch during signal transition at the outputs of the first and second D-latches 711 and 712.

In normal condition, each time a read command READC is received, the reading signal READ triggers the internal synchronization signals ATD, SEN and DLA, and the check signals CHKATD, CHKSEN, and CHKDLA toggle before the reception of a next read command READC. Consequently, the outputs of the first and second D-latches 711 and 712 are always different one from each other so the output of the XNOR gate is always equal to "0".

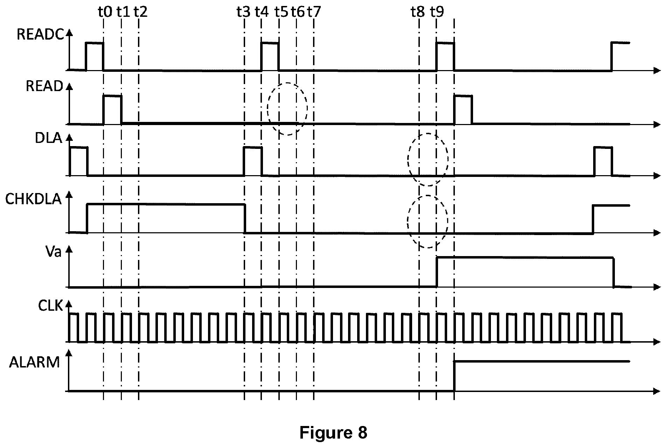

The figure 8 details how the monitoring circuit 710 works. This figure 8 partly reproduces the signals of figure 6 with additional signals which are managed by the memory controller 700. Figure 6 shows the read command READC, the reading signal READ, the global clock signal CLK, a voltage Va corresponding to the output of the XNOR gate 713, and the ALARM signal outputted by the third D-latch 714 in addition to the data latching signal DLA and its corresponding check signal CHKDLA. The read command READC normally precedes the reading signal READ of one period of the global clock signal CLK. When the attack occurs, the reading signal READ is neutralized at time t5 causing the data latching signal DLA not to be activated at time t8. The data latching signal DLA not being activated, the corresponding check signal CHKDLA does not toggle at time t8. At time t9, the next active edge of the read command READC loads a same value of the check signal CHKDLA into the first D-latch 711. Consequently, the outputs of the first and second D-latches 711 and 712 are at a same logical level and the output of the XNOR gate 713 becomes equal to level "1", as it can be seen on the voltage Va, activating the alarm signal ALARM at the output of the third D-latch 714 at the next active edge of the global clock signal CLK.

The circuit of figure 7 enables to detect the attack shown on figure 6. Nevertheless, the attack can also be made directly on one of the internal synchronization signals ATD, SEN and DLA.

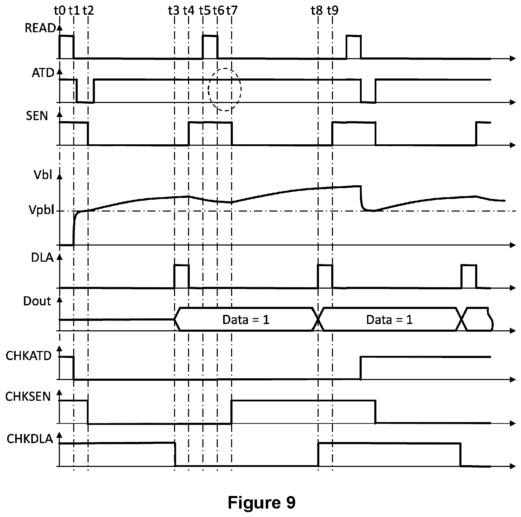

Figure 9 shows an example of attack on the address validation signal ATD wherein the address validation signal ATD is neutralized at t5. Consequently, the address is not set to a new address and the voltage of the bit line continue increase because the same bit is read. At time t8, the data latching signal DLA is activated, and the latch 372 memorizes and provides at its output a bit value equal to "1" instead of the value "0".

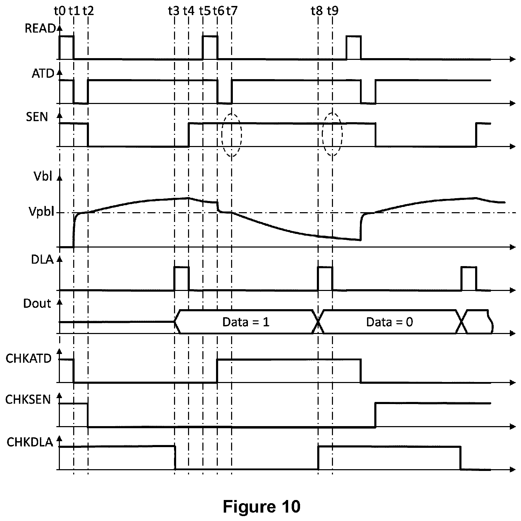

Figure 10 shows an example of attack on the sensing signal SEN wherein the sensing signal SEN is neutralized at time t7. Consequently, the mirror transistor 361 is not connected to the bit line BLi through the sensing transistor 362 and the bit line is not polarized by the constant current. Whatever the value memorized by the selected memory cell MCj,i+1, the bit line is discharged by the leakage current with or without the current drawn by the selected memory cell MCj,i+1. At time t8, the data latching signal DLA is activated, and the latch 372 memorizes and provides at its output a bit value equal to "0" whatever the value of the selected memory cell.

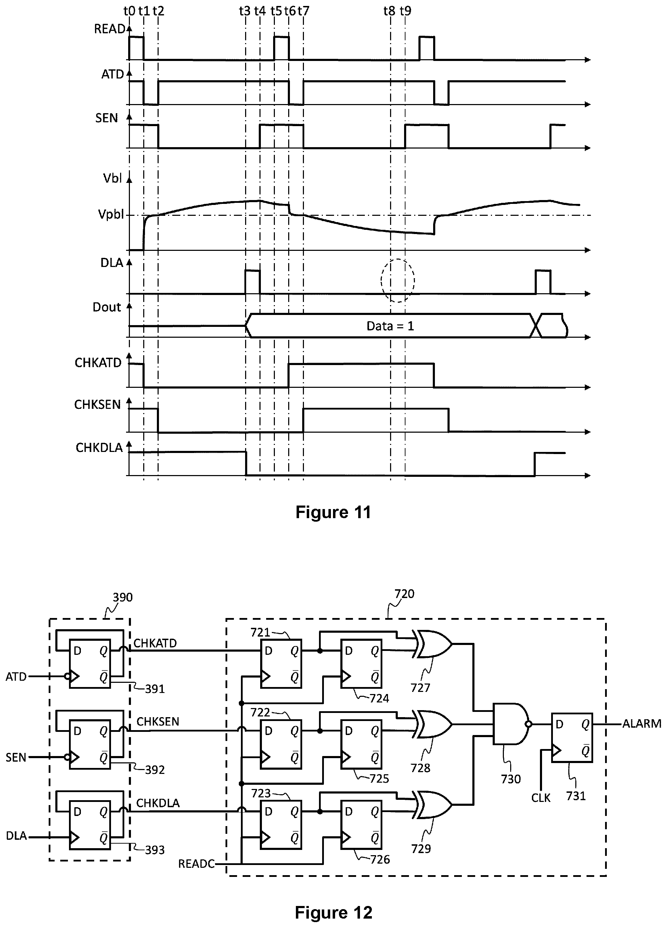

Figure 11 shows an example of attack on the data latching signal DLA wherein the data latching signal DLA is neutralized at t8. Consequently, the latch 372 still memorizes and provides at its output a bit value corresponding to the previous reading operation, which is equal to "1" instead of the value "0".

For these three attacks, only one of the check signals (CHKATD, CHKSEN, CHKDLA) has not toggled. The circuit shown on figure 7 can only detect one of these attacks. For detecting all these attacks, all the check signals (CHKATD, CHKSEN, CHKDLA) should be monitored.

Figure 12 shows an example of monitoring circuit 720 that is included in the memory controller 700 for detecting an attack and for raising an alarm signal ALARM when an attack is detected on only one of the internal check signals CHKATD, CHKSEN, or CHKDLA. The monitoring circuit 720 comprises three signal inputs, each receiving one of the check signals CHKATD, CHKSEN, and CHKDLA, a clock input receiving the read command READC coming from the CPU 100 or from one peripheral unit 400, and an output providing the alarm signal ALARM when one or more of the check signals CHKATD, CHKSEN, or CHKDLA has not toggled following the reception of a read command READ.

The figure 12 shows a monitoring circuit 720 which activates the alarm signal ALARM when at least one of the check signals CHKATD, CHKSEN, and CHKDLA has not toggled following the reception of a read command READC. The monitoring circuit 720 comprises as many first D-latches 721, 722, and 723 as is the number of check signals CHKATD, CHKSEN, and CHKDLA to monitor. The monitoring circuit 720 comprises a same number of second D-latches 724, 725, and 726 and a same number of XOR gates 727, 728, and 729 as the number of first D-latches 721 to 723. The monitoring circuit 720 further comprises a NAND gate 730, and optionally a third D-latch 731. The first to third D-latches 721 to 726, and 731 each comprise a signal input, a clock input, and an output reproducing and memorizing the signal input each time an active edge is received on its clock input. The input signal of each first D-latch 721 to 723 receives one of the check signals CHKATD, CHKSEN, and CHKDLA. The input signal of each second D-latches 724 to 726 is connected to the output of one of the first D-latch 721 to 723. The clock input of all the first and second D-latches 721 to 726 receives the read command READC. Each XOR gate 727 to 729 comprises two inputs and one output. The inputs of each XOR gate are respectively connected to the output of one first D-latch 721 to 723 and to the output of one second D-latch 724 to 726 having its output connected to the output of a same first D-latch 721 to 723. The NAND gate 730 comprises one output and a number of inputs equal to the number of XOR gates 727 to 729. Each input of the NAND gate 730 is connected to the output of one of the XOR gates 727 to 729. The output of the NAND gate 730 provides the alarm signal ALARM to the signal input of the third D-latch 731. The clock input of the third D-latch 731 receives the global clock signal CLK. The third D-latch 731 is used for formatting the alarm signal ALARM in such a way the alarm signal is synchronized with other information exchanged on the control bus and can also prevents having false raising of the alarm signal ALARM caused by a glitch during signal transition at the outputs of the first and second D-latches 721 to 726.

In normal condition, each time a read command READC is received, the reading signal READ triggers the internal synchronization signals ATD, SEN and DLA, and the check signals CHKATD, CHKSEN, and CHKDLA toggle before the reception of a next read command READC. Consequently, the outputs of the first and second D-latches 721 to 726 corresponding to a same check signal CHKATD, CHKSEN, or CHKDLA are always different one from each other. So, the outputs of the XOR gates 727 to 729 are always equal to "1". All the inputs of the NAND gate 730 being equal to "1", the output of the NAND gate 730 is equal to "0".

When one of the attacks shown on figures 9 to 11 occurs, the next active edge of the read command READC loads a same value of one check signal into one of the first D-latch 721 to 723. Consequently, the outputs of one first and one second D-latches 721 to 726 corresponding to said neutralized check signal are at a same logical level and the output of the XOR gate becomes equals to level "0". One input of the NAND gate 730 being equals to "0", the output of the NAND gate 730 becomes equal to "1", activating the alarm signal ALARM.

The person skilled in the art can notice that the monitoring circuit 720 corresponds to the monitoring circuit 710 with a multiplication of first and second D-latches. The XNOR gate 713 is replaced by a NAND gate 730 connected to one XOR gate 727 to 729 corresponding to each check signal CHKATD, CHKSEN, or CHKDLA. The number of first and second D-latches 721 to 726 and XOR gates 727 to 729 can vary according to the number of internal synchronization signals ATD, SEN, and DLA that can be monitored through the check signals CHKATD, CHKSEN, and CHKDLA.

In addition, a man of the art can make a choice to have an alarm signal active at low state instead of high state as disclosed in the present document. On the monitoring circuit 710 of figure 7, this can be easily made by simply replacing the XNOR gate 713 by another XOR-type gate like an XOR gate, or by using the inverted output *Q̅* of the third D-latch. On the monitoring circuit 720 of figure 12, this can be easily made by simply replacing the NAND gate 730 by another AND-type gate like an AND gate, or by using the inverted output *Q̅* of the third D-latch.

Many other variants can be imagined by one person skilled in the art without departing of the invention as defined in the annexed set of claims.

## Claims

1. A method for detecting a reading error caused by an attack of an integrated circuit comprising a non-volatile memory (300) having a synchronization circuit (330) for providing internal synchronization signals (ATD, SEN, DLA) for controlling read amplifiers (370) and performing a read operation when a reading signal (READ) is activated, **characterized in that** the non-volatile memory (300) provides at least one check signal (CHKATD, CHKSEN, CHKDLA), said check signal toggling each time an internal synchronization signal (ATD, SEN, DLA) comprises an active edge.

2. The method of claim 1, wherein the integrated circuit comprises at least one memory controller (700) interfacing the non-volatile memory (300) with other elements (CPU, 400) of said integrated circuit, wherein the memory controller (700) activates the reading signal (READ) in response to the reception of a read command (READC) from the other elements (CPU, 400) of the integrated circuit, wherein the memory controller (700) monitors the at least one check signal (CHKATD, CHKSEN, CHKDLA), and verifies after each reception of the read command (READC) that the check signal (CHKATD, CHKSEN, CHKDLA) has toggled following the reception of the last read command (READC), and wherein the memory controller (700) activates an alarm signal (ALARM) when the check signal has not toggled.

3. The method according to claim 2, wherein the memory provides several check signals (CHKATD, CHKSEN, CHKDLA), and wherein the memory controller (700) verifies after each reception of the read command (READC) that all the check signals (CHKATD, CHKSEN, CHKDLA) have toggled, and activates an alarm signal (ALARM) when at least one of the check signals (CHKATD, CHKSEN, CHKDLA) has not toggled.

4. A non-volatile memory circuit (300) comprising a plurality of memory cells (MC1,1 to MCm,n), a synchronization circuit (330) for providing internal synchronization signals (ATD, SEN, DLA) for controlling read amplifiers (370) and performing a read operation on at least one of the memory cells (MC1,1 to MCm,n) when a reading signal (READ) is activated, **characterized in that** the non-volatile memory circuit (300) comprises at least one check circuit (390), said check circuit (390) receiving at least one internal synchronization signal (ATD, SEN, DLA) and providing at least one check signal (CHKATD, CHKSEN, CHKDLA), said check signal toggling each time an internal synchronization signal (ATD, SEN, DLA) comprises an active edge.

5. The non-volatile memory circuit (300) of claim 4, wherein the check circuit (390) receives a plurality of internal synchronization signals (ATD, SEN, DLA) and provides a plurality of check signals (CHKATD, CHKSEN, CHKDLA).

6. The non-volatile memory circuit (300) of one of the claims 4 or 5, wherein the check circuit (390) comprises a toggle flip-flop (391, 392, 393) receiving on a clock input one of the internal synchronization signals (ATD, SEN, DLA) for toggling an output each time of the internal synchronization signal (ATD, SEN, DLA) comprises an active edge.

7. An integrated circuit comprising a non-volatile memory circuit according to one of the claims 4 to 6, said integrated circuit comprising at least one memory controller (700) activating the reading signal (READ) in response to the reception of a read command (READC), wherein the memory controller (700) comprises a monitoring circuit (710, 720) receiving at least one check signal (CHKATD, CHKSEN, CHKDLA), and the read command (READC), and wherein the monitoring circuit (710, 720) activates an alarm signal (ALARM) when the check signal (CHKATD, CHKSEN, CHKDLA) has not toggled following the reception of a read command (READC).

8. The integrated circuit of the claim 7, wherein the monitoring circuit (710) comprises a first D-latch (711) having one input receiving one of the check signals (CHKATD, CHKSEN, CHKDLA), a second D-latch (712) having one input connected to an output of the first D-latch (711), and an XOR-type gate (713) having one input connected to the output of the first D-latch (711) and another input connected to an output of the second D-latch (712), the first and second D-latches (711, 712) having a clock input receiving the read command (READC) and wherein the output of the XOR-type gate (713) provides the alarm signal (ALARM).

9. The integrated circuit of claim 7 and depending on claim 5, wherein the monitoring circuit (720) activates the alarm signal (ALARM) when at least one of the check signals (CHKATD, CHKSEN, CHKDLA) has not toggled following the reception of a read command (READC).

10. The integrated circuit of the claim 9, wherein the monitoring circuit (720) comprises a plurality of first D-latches (721, 722, 723), each having one input receiving one of the check signals (CHKATD, CHKSEN, CHKDLA), a plurality of second D-latches (724, 725, 726), each having one input connected to an output of one of the first D-latches (721, 722, 723), a plurality of XOR-type gates (727, 728, 729), each having one input connected to the output of one of the first D-latch (721, 722, 723) and another input connected to an output of one of the second D-latch (724, 725, 726), and an AND-type gate (730) having a plurality of inputs, each connected to an output of each XOR-type gate (727, 728, 729), all the first and second D-latches (721 to 726) having a clock input receiving the read command (READC) and wherein the output of the AND-type gate (730) provides the alarm signal (ALARM).
